# EUROPEAN PATENT APPLICATION

(11) **EP 3 748 699 A1**
(43) Date of publication of application: **09.12.2020**
(21) Application number: 18785240.5
(22) Date of filing: 01.06.2018
(51) Int. Cl.: H01L 31/18, H01L 21/687, H01L 21/67

(54) **CARRIER FOR THIN FILM BATTERY PREPARATION AND METHOD FOR PREPARING THIN FILM BATTERY**

(30) Priority: 31.01.2018 CN 201810097035; 31.01.2018 CN 201820167230 U
(71) Applicant: Beijing Apollo Ding Rong Solar Technology Co., Ltd., Beijing 100176 (CN)
(72) Inventor: LIU, Dechen, Beijing 100176 (CN); YANG, Lihong, Beijing 100176 (CN); CHEN, Tao, Beijing 100176 (CN); LI, Xinlian, Beijing 100176 (CN)
(74) Representative: Cohausz & Florack
(86) International application number: PCT/CN2018/089661
(87) International publication number: WO 2019/148724

(57) **Abstract**

There are provided a carrier for preparing a thin-film cell and a method for preparing the thin-film cell, in the field of thin-film cell technology. The carrier has a receiving-chamber matched with a standard substrate used for preparing a standard thin-film cell, the receiving-chamber is partitioned into a plurality of clamping grooves for receiving a sub-substrate having a smaller area than the standard substrate respectively. Each of the clamping grooves has a first opening through which a film layer of the thin-film cell is formed on the sub-substrate. The sub-substrate obtained after the damaged region of the damaged standard substrate is removed is placed into the clamping groove of the carrier by means of splicing, and the subsequent preparation of the film layer may be performed according to the same process procedure and parameters as the standard substrate, to make effective use of the damaged substrate, thereby improving the yield of the thin-film cells and reducing the preparation cost. Based on the non-standard thin-film cell, the sub-substrate that matches therewith may be selected, and a film layer may be prepared with use of a standard thin-film cell production line to obtain a non-standard thin-film cell, which avoids the cutting of a finished thin-film cell and reduces the waste.

## Description

### CROSS-REFERENCE TO RELATED APPLICATION

This application claims priorities to Chinese Patent Application No. 201810097035.X titled "Method for Preparing Thin-film Cell" and Chinese Patent Application No. 201820167230.0 titled "Carrier for Preparing Thin-film Cell", both of which were filed with the Sate Intellectual Property Office of P.R. China on January 31, 2018. The two aforementioned applications are incorporated hereby in their entireties.

### TECHNICAL FIELD

The present disclosure relates to the field of thin-film cell technology, and in particularly to a carrier for preparing a thin-film cell and a method for preparing the thin-film cell.

### BACKGROUND

With the increasing shortage of energy and increasing attention to environmental protection, a proportion of global investment in photovoltaic energy has increased year by year. In the field of photovoltaic power generation, thin-film cells have become a research hotspot in the industry due to their advantages of large area, high efficiency, low production cost, and high quality reliability. In a traditional thin-film cell production process, a plurality of thin-film solar cell units are connected in series with each other via an interconnection structure, so as to be integrated on a large substrate. Standardized cell modules with uniform specifications are formed by using a large-scale, continuous and standard thin-film cell production line.

However, due to its own material properties, the substrate (such as glass) can be easily cracked and damaged during the production process, resulting in a decreased yield rate and an increased preparation cost. Furthermore, when there is a need for a thin-film cell having non-standard size on the application side, it needs to cut an intact or defective finished thin-film cell core into a desired size. However, the cutting of a finished cell is likely to cause breaking, even cracking or damaging, which also results in a waste as well as an increased preparation cost.

### SUMMARY

Based on the above, there are provided a carrier for preparing a thin-film cell and a method for preparing the thin-film cell in the present disclosure. Specifically, the technical solutions are as follows.

In an aspect, there is provided a carrier for preparing a thin-film cell, including: a receiving-chamber matched with a standard substrate configured for preparing a standard thin-film cell, where the receiving-chamber is partitioned into a plurality of clamping grooves configured for receiving a sub-substrate having a smaller area than the standard substrate, and each of the clamping grooves has a first opening through which a film layer of the thin-film cell is formed on the sub-substrate.

In a possible implementation, the standard substrate is provided with a plurality of cell preparation zones; and
the plurality of clamping grooves are matched with shapes and sizes of an integer number of continuous cell preparation zones, respectively.

In a possible implementation, the shapes and the sizes of the plurality of clamping grooves are the same.

In a possible implementation, the standard substrate is provided with the plurality of cell preparation zones forming an M×N matrix, the plurality of clamping grooves form an X×Y matrix, where M, N, X, and Y are integers, and 1≤X≤M, 1≤Y≤N, and (X×Y)> 1.

In a possible implementation, 1/4M<X<1/2M and/or 1/4M<Y<1/2N.

In a possible implementation, at least one of X and Y is 1 or 2.

In a possible implementation, each of the clamping grooves is provided with a second opening through which the sub-substrate is picked or placed, and the second opening is provided at a side of the clamping groove.

In a possible implementation, at least two of the clamping grooves have different structures and sizes.

In a possible implementation, the carrier includes: a base, two side plates, and at least one partition plate, the two side plates are respectively provided on two opposite sides of the base and form the receiving-chamber together with the base, and the at least one partition plate is provided within the receiving-chamber to partition the receiving-chamber into the plurality of clamping grooves.

In a possible implementation, the at least one partition plate is provided in a direction parallel to the two side plates and/or in a direction perpendicular to the two side plates

In a possible implementation, there are at least two partition plates including at least one first partition plate and at least one second partition plate; the at least one first partition plate is provided in a direction parallel to the two side plates and partitions the receiving-chamber into a plurality of sub receiving-chambers that are provided in parallel and have an opening at both ends respectively, and the at least one second partition plate is provided in a direction perpendicular to the two side plates and partitions each of the sub receiving-chambers into the plurality of the clamping grooves .

In a possible implementation, the carrier further includes a limiting plate provided on a top of the clamping groove for limiting a position of the sub-substrate within the clamping groove.

In a possible implementation, a width of the limiting plate is greater than 0 mm and less than 5 mm.

In a possible implementation, the base is provided with a plurality of slots, and the partition plate has plug-in connectors mated with the slots.

In a possible implementation, the carrier is made of quartz, graphite, sapphire, or alumina.

In a possible implementation, the sub-substrate is configured to prepare a non-standard thin-film cell.

In another aspect, there is provided a method for preparing the thin-film cell in the present disclosure, including:
providing any one of the above-mentioned carriers;
obtaining a sub-substrate, and placing the sub-substrate into a clamping groove of the carrier; and
forming, with use of a standard thin-film cell production line, a film layer on the sub-substrate through an opening in the clamping groove to prepare the thin-film cell.

In a possible implementation, the obtaining of the sub-substrate includes:
providing a first substrate provided with a plurality of cell preparation zones;
separating the region where the cell preparation zones are undamaged from the first substrate to obtain a second substrate; and
taking the second substrate as the sub-substrate.

In a possible implementation, the method includes:
providing (S101) the first substrate configured for preparing a standard thin-film cell, and selecting a carrier matched with the first substrate according to the first substrate;
determining (S102) the cell preparation zones that are undamaged and matched with a shape and a size of any empty clamping groove of a plurality of clamping grooves of the carrier, on the first substrate;
separating (S103) the region where the cell preparation zones are undamaged and matched with the shape and the size of the empty clamping groove from the first substrate to obtain the second substrate, and placing the second substrate into the empty clamping groove, until each of the plurality of clamping grooves is provided with the second substrate; and
performing (S104) a subsequent process on the carrier to prepare the thin-film cell.

In a possible implementation, the method further includes:
determining whether there are cell preparation zones, that are undamaged and matched with the shape and the size of any empty clamping groove of the plurality of clamping grooves of the carrier, on the first substrate; if not, discarding the first substrate; and
after the second substrate is placed into the empty clamping groove, determining whether each of the clamping grooves is provided with the second substrate, if not, returning the carrier to step S101.

In a possible implementation, the method includes:
separating (S201) the first substrate according to the shapes and the sizes of the plurality of clamping grooves of the carrier to obtain a plurality of second substrates respectively corresponding to the plurality of clamping grooves; and
placing (S202) the plurality of second substrates into the clamping grooves corresponding therewith, respectively, and performing a subsequent process on the carrier to prepare a thin-film cell,
where the second substrate is matched with a non-standard thin-film cell.

In a possible implementation, the first substrate is a blank substrate, or a substrate provided with a functional layer.

The technical solutions of the embodiments of the present disclosure may have the following beneficial effect.

The carrier provided in the embodiments of the present disclosure has a receiving-chamber matched with a standard substrate used for preparing a standard thin-film cell, and a film layer may be prepared on the sub-substrate 30 through an opening in the clamping groove with use of a standard thin-film cell production line, thereby achieving the preparation of a standard thin-film cell and a non-standard thin-film cell. The sub-substrate having a smaller area than the standard substrate may placed in the clamping grooves, and may come from the undamaged region of the partially damaged standard substrate. It can be seen that the sub-substrate obtained after a damaged region of the damaged standard substrate is removed is placed into the clamping groove of the carrier by means of splicing, and the subsequent preparation of the film layer may be performed according to the same process procedure and parameters as those of the standard substrate, i.e., the standard thin-film cell production line, thereby achieving the effective utilization of the damaged substrate, improving the yield rate of the thin-film cell, and reducing the preparation cost. When preparing a non-standard thin-film cell, the sub-substrate matched therewith may be selected according to the shape and size of the non-standard thin-film cell, and a film layer may be prepared on the sub-substrate with use of a standard thin-film cell production line, thereby obtaining a non-standard thin-film cell, which avoids the cutting of a finished thin-film cell, reduces the waste, and reduces the preparation cost.

### BRIEF DESCRIPTION OF THE DRAWINGS

To describe the technical solutions in the embodiments of the present disclosure more clearly, the following briefly introduces the accompanying drawings required for describing the embodiments. Apparently, the accompanying drawings in the following description show merely some embodiments of the present disclosure, and a person of ordinary skill in the art may still derive other drawings from these accompanying drawings without creative efforts.
FIG. 1 is a schematic diagram of a structure of a standard substrate provided in an embodiment of the present disclosure;
FIG. 2 is a schematic diagram of a structure of a sub-substrate provided in an embodiment of the present disclosure;
FIG. 3 is a schematic diagram of a front-view structure of a carrier provided in an embodiment of the present disclosure;
FIG. 4 is a schematic diagram of a top-view structure of FIG. 3;
FIG. 5 is a schematic diagram of a front-view structure of a carrier provided in another embodiment of the present disclosure; and
FIG. 6 is a flowchart of a preparation process for a thin-film cell provided in an embodiment of the present disclosure.

Reference numerals are as follows:
10-standard substrate, 101-cell preparation zone,
20-carrier, 201-clamping groove, 210-base, 220-side plate,
230-partition plate, 231-first partition plate, 232-second partition plate,
240-limiting plate, 30-sub-substrate

### DETAILED DESCRIPTION

The present disclosure will be described in further detail with reference to the accompanying drawings, so as to clearly present the objects, technical solutions, and advantages of the present disclosure. It should be understood that the described embodiments herein are merely for illustration, rather than limitation of the present disclosure.

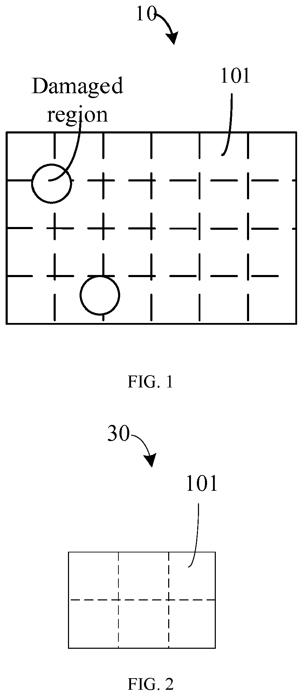

There is provided in the present disclosure a carrier 20 for preparing a thin-film cell. As shown in FIGS. 1-3, the carrier 20 has a receiving-chamber matched with a standard substrate 10 used for preparing a standard thin-film cell. The receiving-chamber is partitioned into a plurality of clamping grooves 201 for receiving sub-substrates 30 having smaller areas than the standard substrate 10 respectively. Each of the clamping grooves 201 has a first opening through which a film layer of the thin-film cell is formed on the sub-substrate 30.

Since the carrier 20 provided in the embodiment of the present disclosure has a receiving-chamber matched with a standard substrate 10 used for preparing a standard thin-film cell, a film layer may be prepared on the sub-substrate 30 through an opening in the clamping groove with use of a standard thin-film cell production line, thereby achieving the preparation of a standard thin-film cell and a non-standard thin-film cell. The sub-substrate 30 having a smaller area than the standard substrate may be placed into the clamping groove, and may come from an undamaged region of a partially damaged standard substrate. It can be seen that the sub-substrate 30 obtained after a damaged region of the damaged standard substrate is removed is placed into the clamping groove of the carrier by means of splicing, and the subsequent preparation of the film layer may be performed according to the same process procedure and parameters as those of the standard substrate, i.e., the standard thin-film cell production line, thereby achieving the effective utilization of the damaged substrate, improving the yield rate of the thin-film cell, and reducing the preparation cost. When preparing a non-standard thin-film cell, the sub-substrate 30 matched therewith may be selected according to the shape and size of the non-standard thin-film cell, and a film layer may be prepared on the sub-substrate 30 with use of a standard thin-film cell production line, thereby obtaining a non-standard thin-film cell, which avoids the cutting of a finished thin-film cell, reduces the waste, and reduces the preparation cost.

As mentioned above, the carrier 20 has a receiving-chamber matched with a standard substrate 10 used for preparing a standard thin-film cell refers to that a shape and a size of the receiving-chamber are the same as a shape and a size of the standard substrate 10, or slightly smaller or larger than a shape and a size of the standard substrate 10, such that a plurality of undamaged regions in the standard substrate 10, after being spliced by the carrier 20, may have nearly the same shape and size as the standard substrate 10, which may proceed to the subsequent process together with the standard substrate 10. Herein, the subsequent process refers to a process of forming a film layer on a sub-substrate or forming a remaining part of a film layer on a sub-substrate having a part of a film layer.

As shown in FIG. 1, the standard substrate 10 is provided with a plurality of cell preparation zones 101. In an embodiment of the present disclosure, the plurality of clamping grooves 201 may be matched with a shape and a size of an integer number of continuous cell preparation zones 101, respectively. The integer number of continuous cell preparation zones 101 may be two, three, four, five, six, or more continuous cell preparation zones 101.

For example, the shape and size of each of the clamping grooves 201 are the same as or slightly larger than the shape and size of one, two, three, or more continuous cell preparation zones 101, such that the one, two, three, or more continuous cell preparation zones 101 may be received and locked in the clamping grooves 201.

Herein, the above-mentioned "forming a film layer of the thin-film cell on the sub-substrate 30 through the first opening" refers to that, when a film layer is formed on the sub-substrate 30, the raw material for preparing the film layer may be fed into the clamping groove 201 through the first opening, and be further disposed on the sub-substrate 30 to form the film layer. That is, in the subsequent preparation process of the thin-film cell, each of the film layers of the thin-film cell may be formed in the cell preparation zones 101 through the first opening (for example, using a deposition method). Exemplarily, the first opening mentioned above may be an upward opening.

It can be understood that each of the clamping grooves 201 is used to receive one sub-substrate 30. The plurality of clamping grooves 201 within the carrier 20 may have a regular geometric shape, such as rectangle, circle, and other polygon, or may have an irregular geometric shape. The structures and sizes of the plurality of clamping grooves 201 may be all the same, or may be partially the same, or may be all different, which will be respectively described below.

In a possible example, the structures and sizes of the plurality of clamping grooves 201 are all the same. In this way, each of the standard substrates 10 may be cut and spliced by using the same standard, thereby facilitating a large-scale production, which not only simplifies an acquisition process of the sub-substrate 30, but also facilitates the interconnection among the thin-film cells prepared by the plurality of sub-substrates 30.

For example, the standard substrate 10 is provided with a plurality of cell preparation zones 101 forming an M×N matrix, and the plurality of clamping grooves 201 form an X×Y matrix, where M, N, X, and Y are integers, 1≤X≤M, 1≤Y≤N, and (X×Y)>1.

It can be known from the above that each of the clamping grooves 201 may be matched with a shape and a size of the cell preparation zones in the (M/X)×(N/Y) matrix, and M/X and N/Y are integers.

The above-mentioned M×N matrix may be set according to the requirements in the actual scale production process, or it may be the existing matrix arrangement in the actual scale production process. The X×Y matrix may be set according to the actual needs. When the values of X and Y are smaller, the number of the clamping grooves is smaller, and the number of the cell preparation zones 101 that each of the clamping grooves 201 needs to receive is more, and in case that the standard substrate 10 is damaged, for example, when a sub-substrate 30 is separated from the standard substrate 10 by means of cutting, the number of times that the standard substrate 10 is cut is also reduced. However, when the values of X and Y are excessively small, even if the degree of damage to the standard substrate 10 is small, there still may be no regions which are undamaged, continuous and matched with the shapes and sizes of the clamping grooves, so that the undamaged regions in the standard substrate 10 cannot be used in the next process by means of splicing by the carrier, resulting in a decreased utilization rate of the standard substrate 10. When the values of X and Y are larger, the number of the clamping grooves 201 is larger, and the number of the cell preparation zones that each of the clamping grooves 201 needs to receive is less, that is, the standard substrate 10 may be cut into smaller sections, and only the sections that are damaged are discarded, thereby increasing the utilization rate of the standard substrate 10, but the number of times that the standard substrate 10 is cut is more. Based on the above considerations, it is possible that 1/4M<X<1/2M and/or 1/4N<Y<1/2N. Further, at least one of X and Y is 1 or 2.

For the pick-and-place of the sub-substrate 30 in the clamping groove 201, the sub-substrate 30 may be placed and picked through the first opening at the top of the clamping groove 201, or through a second opening at a side of the clamping groove 201, which is also called a side opening, so as to facilitate the pick-and-place of the sub-substrate 30 through the second opening. In an example, the side of each of the clamping grooves 201 is provided with a second opening through which the sub-substrate 30 can be placed and picked. Through the second opening, the pick-and-place process of the sub-substrate 30 can be made more convenient, which avoids the damage during the pick-and-place process.

In another possible example, for the carrier 20, structures and sizes of at least two clamping grooves 201 are not the same, that is, the structures and sizes of the clamping grooves 201 may be partially or all different, which not only improve the utilization rate of the damaged substrate, but also facilitate the preparation of various types of non-standard thin-film cells.

The formation of the clamping groove 201 mentioned above will be described below by defining a structure of the carrier 20.

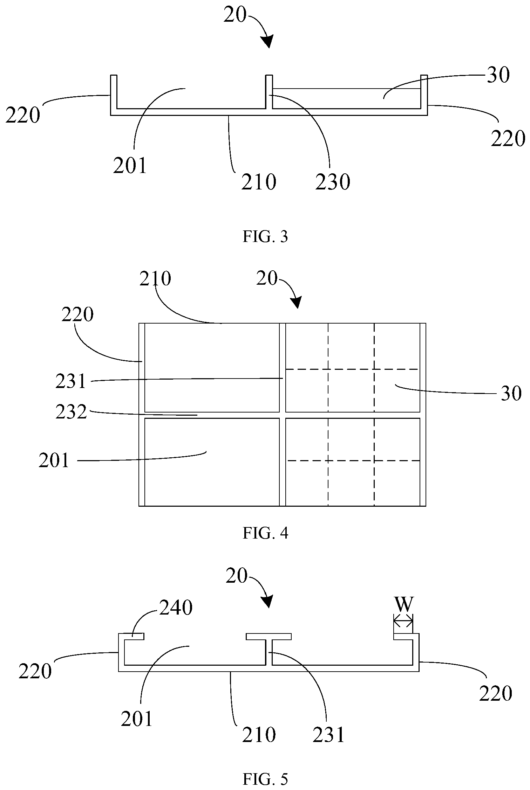

As an example, as shown in FIG. 3, the carrier 20 includes a base 210, two side plates 220, and at least one partition plate 230. The two side plates 220 are respectively provided on two opposite sides of the base 210, and form a receiving-chamber together with the base 210. At least one partition plate 230 is provided in the receiving-chamber, so as to partition the receiving-chamber into a plurality of clamping grooves 201.

Herein, the two side plates 220 are respectively provided on two opposite sides of the base 210, which limits a position of the periphery of the base 210 and ensures that the base 210 has a side opening at the same time, thereby facilitating the pick-and-place of the sub-substrate 30. The side plates 220 may be vertically connected with the base 210.

Considering that the thin-film cells are mostly in the form of rectangular block, in an embodiment of the present disclosure, at least one partition plate 230 is provided in a direction parallel to the two side plates 220 and/or in a direction perpendicular to the two side plates 220.

For example, as shown in FIG. 4, there are at least two partition plates 230, including at least one first partition plate 231 and at least one second partition plate 232. The at least one first partition plate 231 is provided in a direction parallel to the two side plates 220 and partitions the receiving-chamber into a plurality of sub receiving-chambers arranged in parallel and having openings at both ends. The at least one second partition plate 232 is provided in a direction perpendicular to the two side plates 220 and partitions each of the sub receiving-chambers into a plurality of clamping grooves 201.

In a possible example, the first partition plate 231 may be provided in plurality, and the second partition plate 232 may be provided in one, so as to partition each of the sub receiving-chambers into two clamping grooves 201 each having one side opening, so that each of the clamping grooves 201 has a side opening, which facilitates the pick-and-place of the sub-substrate 30.

In a possible example, the first partition plate 231 and the second partition plate 232 may each be provided in plurality. In this case, the first partition plate 231 and/or the second partition plate 232 at the non-peripheral region of the receiving-chamber may be provided with side openings that communicate with each other, which facilitates the pick-and-place of the sub-substrate 30.

There may be a flip-chip process during the preparation process of the film layer of the thin-film cell. To prevent the sub-substrate 30 from falling out of the clamping groove 201, as shown in FIG. 5, the carrier 20 provided in an embodiment of the present disclosure also includes a limiting plate 240. The limiting plate 240 is provided on the top of the clamping groove 201 for limiting the position of the substrate within the clamping groove 201, that is, for limiting the movement of the sub-substrate 30 relative to the carrier 20 in a thickness direction of the sub-substrate 30.

Herein, the limiting plate 240 may be provided at a periphery of the clamping groove 201 and may be provided parallel to the base 210. A distance between the limiting plate 240 and the base 210 may be a thickness of the first substrate.

A width W of the limiting plate 240 is greater than 0 mm and less than 5 mm, and may be, for example, 2 mm, 2.5 mm, 3 mm, 3.5 mm, 4 mm, 4.5 mm, 4.8 mm, etc. This range may prevent the sub-substrate 30 from falling out of the clamping groove 201 when being flip-chip mounted, and may not affect the subsequent preparation of each of the functional film layers.

In order to improve the adaptability of the carrier 20, structures and the numbers of the plurality of clamping grooves 201 may be adaptively changed. Based on this, the base 210 may be provided with a plurality of slots, and the partition plates 230 may be provided with plug-in connectors mated with the slots. By means of plugging, the partition plates 230 may be detachably connected with the slots on the base 210. By adjusting the plugging manner of the partition plates 230, the structure and number of the clamping grooves 201 may be adjusted. In order to facilitate the adjustment of the structure and the number of the clamping grooves 201, the partition plates 230 may be plugged into a part of the slots.

In embodiments of the present disclosure, with use of a standard thin-film cell production line, the above-mentioned carrier 20 may be used to prepare a standard thin-film cell and a non-standard thin-film cell. When preparing a non-standard thin-film cell, the shape and size of the sub-substrate 30 are matched with the shape and size of the non-standard thin-film cell to be prepared, that is, the adopted sub-substrate 30 is used to prepare a non-standard thin-film cell.

Considering that the production process of the thin-film cell is adopted in the subsequent film layer preparation process, the above-mentioned carrier 20 should be suitable for a thin-film cell preparation process. Based on this, the carrier 20 may be made of quartz, graphite, sapphire, or alumina.

In another aspect, there is further provided in an embodiment of the present disclosure a preparation method for a thin-film cell, and the method includes the following steps:
providing any one of the carriers described above;
obtaining a sub-substrate 30, and placing the sub-substrate 30 into a clamping groove of the carrier; and
forming, with use of a standard thin-film cell production line, a film layer on the sub-substrate through an opening in the clamping groove to prepare the thin-film cell described above.

In an embodiment of the present disclosure, a first substrate may be a standard substrate used in a conventional thin-film cell preparation process, and each of cell preparation zones 101 is used to prepare a thin-film cell unit. When the first substrate is damaged, the undamaged regions can be separated, for example, by means of cutting, and placed into the clamping grooves 201 of the carrier 20, and the plurality of undamaged regions on the first substrate are spliced by the carrier 20 into a spliced substrate corresponding to the first substrate. When proceeding to the subsequent process, the same process procedure and parameters as the first substrate may be used for the subsequent preparation (with use of a standard thin-film cell production line), which not only has no affection on the subsequent process, but also avoids the waste of material, improves the utilization rate of material, improves the production yield of the thin-film cell, and reduces the preparation cost.

Herein, the first substrate is a blank substrate (not provided with a film layer) or a substrate provided with a functional layer. Herein, the functional layer can be understood as the above-mentioned film layer. For example, a substrate provided with a functional layer may be partially provided with a film layer, for example, it may be a substrate provided with an electrode layer, or a substrate provided with an electrode layer and a light absorbing layer, or a substrate provided with an electrode layer, a light absorbing layer, and a buffer layer, or a substrate provided with an electrode layer, a light absorbing layer, a buffer layer, and a window layer. In a possible example, the first substrate may be a substrate provided with an electrode layer, a light absorbing layer, and a buffer layer, and the preparation of the film layer performed thereon includes subsequent processes such as a preparation of a window layer.

Herein, the sub-substrate 30 may be obtained by: providing a first substrate provided with a plurality of cell preparation zones, and separating a region where the cell preparation zones are undamaged from the first substrate to obtain a second substrate. This second substrate is used as the sub-substrate 30. It can be seen that the above-mentioned first substrate may be understood as a mother substrate from which the sub-substrate is separated.

The above-mentioned separation ways may be cutting.

A preparation method for a standard thin-film cell and a preparation method for a non-standard thin-film cell are slightly different, which are respectively described below.

The preparation method for a standard thin-film cell may include the following steps:
providing a first substrate used for preparing a standard thin-film cell, and selecting a carrier matched therewith according to the first substrate in step S101;
determining cell preparation zones on the first substrate, where the cell preparation zones are undamaged and matched with a shape and a size of any empty clamping groove of a plurality of clamping grooves of the carrier in step S102; and
separating a region where the cell preparation zones are undamaged and matched with the shape and the size of the empty clamping groove from the first substrate to obtain a second substrate, and placing the second substrate into the empty clamping groove, until each of the plurality of clamping grooves is provided with the second substrate in step S103.

Herein, the first substrate is matched with a standard thin-film cell.

Further, the above preparation method further includes the following steps: determining whether there are cell preparation zones, that are undamaged and matched with the shape and the size of any empty clamping groove of the plurality of clamping grooves of the carrier, on the first substrate; if not, discarding the first substrate; and
determining, after the second substrate is placed into the empty clamping groove, whether each of the clamping grooves is provided with the second substrate; if not, returning the carrier to step S101.

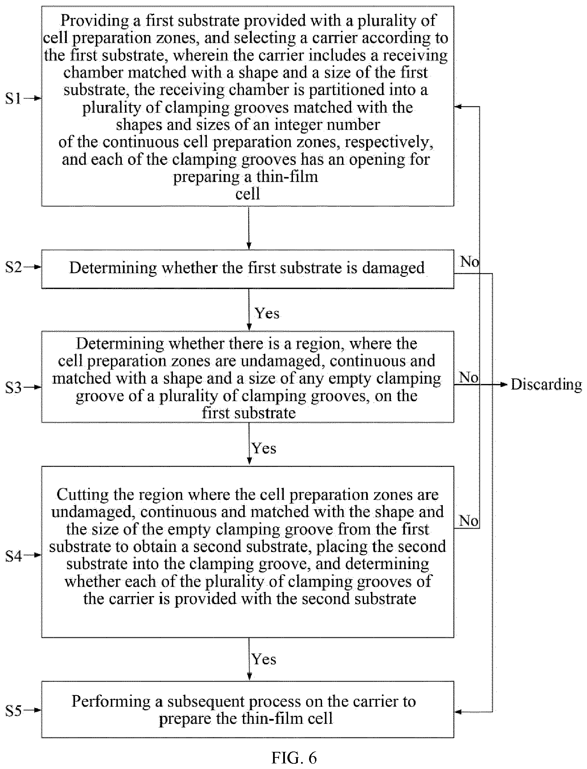

Based on the above, and specifically, as shown in FIG. 6, the above mentioned preparation method may include the following steps:
providing a first substrate provided with a plurality of cell preparation zones 101, and selecting a carrier 20 according to the first substrate in step S1;
determining whether the first substrate is damaged in step S2, if the first substrate is damaged, proceeding to step S3; and if the first substrate is undamaged, proceeding to step S5;
determining whether there is a region, where the cell preparation zones are undamaged, continuous and matched with a shape and a size of any empty clamping groove of a plurality of clamping grooves 201, on the first substrate in step S3; if so, proceeding to step S4; and if not, discarding the first substrate;
cutting the region where the cell preparation zones are undamaged, continuous and matched with the shape and the size of the empty clamping groove from the first substrate to obtain a second substrate 12, placing the second substrate 12 into the clamping groove 201, and determining whether each of the plurality of clamping grooves 201 of the carrier 20 is provided with the second substrate 12 in step S4, if so,
proceeding to step S5, and if not, returning the carrier 20 to step S1; and
performing a subsequent process on the carrier 20 to prepare the thin-film cell in step S5, and that is, forming, with use of a standard thin-film cell production line, a film layer of the thin-film cell on the second substrate through an opening in the clamping groove 201.

In step S2, the manner of determining whether the first substrate is damaged is not limited, and it may be achieved by visual inspecting or by detecting and determining with a professional detection device.

In step S3, the region where the cell preparation zones are undamaged, continuous and matched with the shape and the size of the clamping grooves refers to a continuous region which is formed by one, two, three, or more cell preparation zones 201 that are undamaged. In case that there is no region, where the cell preparation zones are undamaged, continuous and matched with the shape and the size of the clamping grooves, on the first substrate: on one hand, the first substrate cannot proceed to the subsequent step S5 by means of cutting and splicing by the carrier, and on the other hand, it indicates that the first substrate is damaged seriously, even if the first substrate proceeds directly to the subsequent step S5, the resulting thin-film cell still has many defects, which results in the serious waste of material. Therefore, the first substrate may be discarded. Of course, those skilled in the art can also make the first substrate directly proceed to the subsequent step S5, so as to continue to using the first substrate according to the actual needs.

In step S4, when the degree of damage to the first substrate is small, there may be a plurality of independent regions, where the cell preparation zones are undamaged, continuous and matched with the shape and the size of the clamping grooves, on the first substrate. In this case, each of the regions where the cell preparation zones are undamaged, continuous and matched with the shape and the size of the clamping grooves may be cut from the first substrate and then be placed into the plurality of clamping grooves 201 one by one. In an embodiment, referring to FIG. 2 to FIG. 4, when the first substrate is damaged, and there are two independent cell preparation zones of the (M/X)×(N/Y) matrix which are undamaged, the two independent cell preparation zones of the (M/X)×(N/Y) matrix are cut and then placed into two clamping grooves 201, respectively.

When each of the clamping grooves 201 of the carrier 20 is provided with the second substrate 12, i.e., a spliced substrate corresponding to the first substrate is obtained by splicing, at this point, the carrier 20 may proceed to the subsequent process. The subsequent process of the carrier 20 may be completely the same as the subsequent process of the first substrate, thereby saving the material, improving the production yield of the thin-film cell and reducing the preparation cost, without changing the process parameters and conditions.

An embodiment of the present disclosure further relates to a method for preparing a non-standard thin-film cell. In this case, the preparation method includes the following steps:
separating a first substrate according to shapes and sizes of a plurality of clamping grooves of a carrier to obtain a plurality of second substrates respectively corresponding to the plurality of clamping grooves in step S201; and
placing the plurality of second substrates into corresponding clamping grooves, and
performing a subsequent process on the carrier to prepare a thin-film cell in step S202.

The second substrate is matched with the non-standard thin-film cell, that is, the above-mentioned clamping grooves 201 are matched with the shapes and sizes of the non-standard thin-film cell module that needs to be prepared.

In the step S202, the subsequent process may be performed after each of the plurality of clamping grooves may be provided with the second substrate.

Based on the above, and specifically, the above-mentioned preparation method may include the following steps:
providing a first substrate used for preparing a standard thin-film cell module, and
selecting a carrier according to the first substrate, the first substrate has a plurality of cell preparation zones in step S1, where the carrier has a receiving-chamber matched with a shape and a size of the first substrate, the receiving-chamber is partitioned into a plurality of clamping grooves, and each of the clamping grooves is matched with a shape and a size of the non-standard thin-film cell module;
cutting the first substrate according to the shape and the size of the plurality of clamping grooves to obtain second substrates respectively corresponding to the plurality of clamping grooves in step S2; and
placing the plurality of second substrates into the clamping grooves corresponding to the plurality of second substrates, and performing a subsequent process on the carrier to obtain a plurality of non-standard thin-film cell modules in step S3.

The shape and size of the above-mentioned non-standard thin-film cell module are determined according to the actual needs of the application side. The first substrate may be a standard substrate used in the preparation of a standard thin-film cell module. In a second implementation of the present disclosure, the first substrate is directly cut according to the shape and size of the non-standard thin-film cell module, and after that, a spliced substrate corresponding to the first substrate is spliced through the carrier for a subsequent process. A plurality of non-standard thin-film cell modules are directly obtained after the process. Compared with the traditional method in which a thin-film cell core prepared from a standard substrate is cut to obtain a non-standard thin-film cell module, defects caused by cutting a finished thin-film cell core are avoided, production yield and material utilization rate are improved, and the preparation cost is saved.

In a possible example, the above preparation method may be used to prepare non-standard thin-film cell modules with the same shapes and sizes. In this case, the shapes and sizes of the plurality of clamping grooves 201 may be all the same, which facilitates a large-scale production. When the plurality of cell preparation zones 101 form an M×N matrix, the plurality of clamping grooves 201 may form an X×Y matrix, and each of the clamping grooves 201 may matched with the shape and size of the cell preparation zones of an (M/X)×(N/Y) matrix, where M, N, X, Y, M/X, and N/Y are all integers, and 1≤X≤M, 1≤Y≤N, and (X×Y)>1.

The technical features of the above-described embodiments may be combined arbitrarily. For brevity of description, not all the possible combinations of the technical features of the above-described embodiments are described. However, any combination of the technical features, as long as there is no contradiction therein, should be considered to be within the scope of the present description.

The above-mentioned embodiments merely represent several implementations of the present disclosure, and the description thereof is specific and detailed, but they should not be construed as a limitation to the scope of the disclosure. It should be noted that, for those skilled in the art, several variations and improvements can be made without departing from the concept of the present disclosure, which are all within the protection scope of the present disclosure. Therefore, the protection scope of the present disclosure should be defined by the appended claims.

## Claims

1. A carrier (20) for preparing a thin-film cell, comprising: a receiving-chamber matched with a standard substrate (10) configured for preparing a standard thin-film cell, wherein the receiving-chamber is partitioned into a plurality of clamping grooves (201) configured for receiving a sub-substrate (30) having a smaller area than the standard substrate (10), and each of the clamping grooves (201) has a first opening through which a film layer of the thin-film cell is formed on the sub-substrate (30).

2. The carrier (20) for preparing the thin-film cell as claimed in claim 1, wherein the standard substrate (10) is provided with a plurality of cell preparation zones; and
the plurality of clamping grooves (201) are matched with shapes and sizes of an integer number of continuous cell preparation zones , respectively.

3. The carrier (20) for preparing the thin-film cell as claimed in claim 2, wherein the structures and the sizes of the plurality of clamping grooves (201) are the same.

4. The carrier (20) for preparing the thin-film cell as claimed in claim 3, wherein the standard substrate (10) is provided with the plurality of cell preparation zones (101) forming an M×N matrix, the plurality of clamping grooves (201) form an X×Y matrix, wherein M, N, X, and Y are integers, and 1≤X≤M, 1≤Y≤N, and (X×Y)>1.

5. The carrier (20) for preparing the thin-film cell as claimed in claim 4, wherein 1/4M<X<1/2M and/or 1/4M<Y<1/2N.

6. The carrier (20) for preparing the thin-film cell as claimed in claim 4, wherein at least one of X and Y is 1 or 2.

7. The carrier (20) for preparing the thin-film cell as claimed in claim 1, wherein each of the clamping grooves (201) is provided with a second opening through which the sub-substrate is picked or placed, and the second opening is provided at a side of the clamping groove (201).

8. The carrier (20) for preparing the thin-film cell as claimed in claim 1, wherein at least two of the clamping grooves (201) have different structures and sizes.

9. The carrier (20) for preparing the thin-film cell as claimed in any one of claims 1 to 8, wherein the carrier (20) comprises: a base (210), two side plates (220), and at least one partition plate (230), the two side plates (220) are respectively provided on two opposite sides of the base (210) and form the receiving-chamber together with the base (210), and the at least one partition plate (230) is provided within the receiving-chamber to partition the receiving-chamber into the plurality of clamping grooves (201).

10. The carrier (20) for preparing the thin-film cell as claimed in claim 9, wherein the at least one partition plate (230) is provided in a direction parallel to the two side plates (220) and/or in a direction perpendicular to the two side plates (220).

11. The carrier (20) for preparing the thin-film cell as claimed in claim 10, wherein there are at least two partition plates (230) comprising at least one first partition plate (231) and at least one second partition plate (232); the at least one first partition plate (231) is provided in a direction parallel to the two side plates (220) and partitions the receiving-chamber into a plurality of sub receiving-chambers that are provided in parallel and have an opening at both ends respectively, and the at least one second partition plate (232) is provided in a direction perpendicular to the two side plates (220) and partitions each of the sub receiving-chambers into the plurality of the clamping grooves (201).

12. The carrier (20) for preparing the thin-film cell as claimed in claim 9, wherein the carrier (20) further comprises a limiting plate (240) provided on a top of the clamping groove (201) for limiting a position of the sub-substrate within the clamping groove (201).

13. The carrier (20) for preparing the thin-film cell as claimed in claim 12, wherein a width of the limiting plate (240) is greater than 0 mm and less than 5 mm.

14. The carrier (20) for preparing the thin-film cell as claimed in claim 9, wherein the base (210) is provided with a plurality of slots, and the partition plate (230) has plug-in connectors mated with the slots.

15. The carrier (20) for preparing the thin-film cell as claimed in claim 1, wherein the carrier (20) is made of quartz, graphite, sapphire, or alumina.

16. The carrier (20) for preparing the thin-film cell as claimed in claim 1, wherein the sub-substrate (30) is configured to prepare a non-standard thin-film cell.

17. A method for preparing a thin-film cell, comprising: providing the carrier as claimed in any one of claims 1 to 16;
obtaining a sub-substrate, and placing the sub-substrate into a clamping groove of the carrier; and
forming, with use of a standard thin-film cell production line, a film layer on the sub-substrate through an opening in the clamping groove to prepare the thin-film cell.

18. The method for preparing the thin-film cell as claimed in claim 17, wherein the obtaining of the sub-substrate comprises: providing a first substrate provided with a plurality of cell preparation zones;
separating the region where the cell preparation zones are undamaged from the first substrate to obtain a second substrate; and
taking the second substrate as the sub-substrate.

19. The method for preparing the thin-film cell as claimed in claim 18, comprising:
providing (S101) the first substrate configured for preparing a standard thin-film cell, and selecting a carrier matched with the first substrate according to the first substrate;
determining (S102) the cell preparation zones that are undamaged and matched with a shape and a size of any empty clamping groove of a plurality of clamping grooves of the carrier, on the first substrate;
separating (S103) the region where the cell preparation zones are undamaged and matched with the shape and the size of the empty clamping groove from the first substrate to obtain the second substrate, and placing the second substrate into the empty clamping groove, until each of the plurality of clamping grooves is provided with the second substrate; and
performing (S104) a subsequent process on the carrier to prepare the thin-film cell.

20. The method for preparing the thin-film cell as claimed in claim 19, wherein the method further comprises:
determining whether there are cell preparation zones, that are undamaged and matched with the shape and the size of any empty clamping groove of the plurality of clamping grooves of the carrier, on the first substrate; if not, discarding the first substrate; and
after the second substrate is placed into the empty clamping groove, determining whether each of the clamping grooves is provided with the second substrate, if not, returning the carrier to step S101.

21. The method for preparing the thin-film cell as claimed in claim 18, wherein the method comprises:
separating (S201) the first substrate according to the shapes and the sizes of the plurality of clamping grooves of the carrier to obtain a plurality of second substrates respectively corresponding to the plurality of clamping grooves; and
placing (S202) the plurality of second substrates into the clamping grooves corresponding therewith, respectively, and performing a subsequent process on the carrier to prepare a thin-film cell,
wherein the second substrate is matched with a non-standard thin-film cell.

22. The method for preparing the thin-film cell as claimed in any one of claims 17 to 21, wherein the first substrate is a blank substrate, or a substrate provided with a functional layer.
